(19) **Europäisches Patentamt / European Patent Office / Office européen des brevets**

(11) **EP 4 399 572 B1**

(12) **EUROPEAN PATENT SPECIFICATION**

(45) Date of publication and mention of the grant of the patent:
**01.04.2026 Bulletin 2026/14**

(21) Application number: **22761995.4**

(22) Date of filing: **04.08.2022**

(51) International Patent Classification (IPC):
**G03F 7/20** (2006.01)

(52) Cooperative Patent Classification (CPC):
**G03F 7/70616; G03F 7/705; G03F 7/70525;**
**G03F 7/70625; G03F 7/70633**

(86) International application number:
**PCT/EP2022/071985**

(87) International publication number:
**WO 2023/036526 (16.03.2023 Gazette 2023/11)**

(54) **A METHOD OF MONITORING A LITHOGRAPHIC PROCESS AND ASSOCIATED APPARATUSES**

**VERFAHREN ZUR ÜBERWACHUNG EINES LITHOGRAPHISCHEN VERFAHRENS UND ZUGEHÖRIGE VORRICHTUNGEN**

**PROCÉDÉ DE SURVEILLANCE D'UN PROCESSUS LITHOGRAPHIQUE ET APPAREILS ASSOCIÉS**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.09.2021 EP 21195360**
**01.12.2021 EP 21211785**

(43) Date of publication of application:
**17.07.2024 Bulletin 2024/29**

(73) Proprietor: **ASML Netherlands B.V.**
**5500 AH Veldhoven (NL)**

(72) Inventors:
- **BASTANI, Vahid**
  **5500 AH Veldhoven (NL)**
- **ZHANG, Yichen**
  **5500 AH Veldhoven (NL)**
- **DE ATHAYDE COSTA E SILVA, Marsil**
  **5500 AH Veldhoven (NL)**
- **DILLEN, Hermanus, Adrianus**
  **5500 AH Veldhoven (NL)**
- **VAN WIJK, Robert Jan**
  **5500 AH Veldhoven (NL)**

(74) Representative: **ASML Netherlands B.V.**
**Corporate Intellectual Property**
**P.O. Box 324**
**5500 AH Veldhoven (NL)**

(56) References cited:
**WO-A1-2020/094389    WO-A1-2021/037484**
**US-A1- 2021 018 850**

- **GUPTA PUNEET ET AL: "Modeling Edge Placement Error Sistribution in Standard Cell Library", SPIE, PO BOX 10 BELLINGHAM WA 98227-0010 USA, vol. 6156, 14 March 2006 (2006-03-14), SPIE, pages 61560S1 - 61560S12, XP040221740, DOI: 10.1117/12.658580**

**Description**

FIELD OF THE INVENTION

The present invention relates to a metrology apparatus and methods usable, for example, to perform metrology in the manufacture of devices by lithographic techniques. The invention further relates to such methods for monitoring edge placement error or a related metric in a lithographic process.

BACKGROUND ART

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned.

In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a diffraction "spectrum" from which a property of interest of the target can be determined.

Examples of known scatterometers include angle-resolved scatterometers of the type described in US2006033921A1 and US2010201963A1. The targets used by such scatterometers are relatively large, e.g., 40µm by 40µm, gratings and the measurement beam generates a spot that is smaller than the grating (i.e., the grating is underfilled). Examples of dark field imaging metrology can be found in international patent applications US20100328655A1 and US2011069292A1. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target.

Monitoring of patterning performance has been based on separate monitoring of process metrics such as *inter alia* overlay and CD. However, more recently, a preferred patterning performance metric is edge placement error (EPE). The position of the edge of a feature is determined by the feature's lateral position (Overlay) and the size of the feature (CD). Part of this is very local and stochastic in nature; e.g., dependent on local overlay (LOVL) and local CD uniformity (LCDU). Also, Line Edge Roughness (LER) and line width roughness (LWR) may result in very local CD variations. All of these may be important contributors to the EPE performance.

EPE may be measured directly via scanning electron microscope (SEM) inspection, examples of which include e-beam metrology or e-beam inspection. However, this can only be done after the die is completed. Additionally, decapping may be required prior to SEM measurement, which is destructive and wasteful and therefore comes at high cost. Because of this, EPE may be reconstructed from other metrics. WO 2021/037484 A1 discloses a machine learning prediction model determining an edge placement error.

It would be desirable to provide an improved method for reconstructing EPE.

SUMMARY OF THE INVENTION

The invention in a first aspect provides a computer program for determining a placement metric relating to placement of one or more features on a substrate in a lithographic process, the computer program comprising computer readable instructions configured to: obtain setup data comprising placement error contributor data relating to a plurality of placement error contributor parameters and yield data representative of yield; define a statistical model for predicting a yield metric, said statistical model being based on a placement metric, said placement metric being a function of said placement error contributor parameters, and associated model coefficients; fit said model coefficients based on said setup data; and determine said placement metric from said fitted model coefficients.

Further features and advantages of the invention, as well as the structure and operation of various embodiments of the invention, are described in detail below with reference to the accompanying drawings. It is noted that the invention is not limited to the specific embodiments described herein. The invention is limited by the appended claims.

Such embodiments are presented herein for illustrative purposes only. Additional embodiments will be apparent to persons skilled in the relevant art(s) based on the teachings contained herein.

BRIEF DESCRIPTION OF THE DRAWINGS

Embodiments of the invention will now be described, by way of example only, with reference to the accompanying schematic drawings in which corresponding reference symbols indicate corresponding parts, and in which:

Figure 1 depicts a lithographic apparatus;
Figure 2 depicts a lithographic cell or cluster in which an inspection apparatus according to the present invention may be used;
Figure 3 illustrates schematically an inspection apparatus adapted to perform angle-resolved scatterometry and dark-field imaging inspection methods;
Figure 4 is a flowchart describing an EPE reconstruction method according to an embodiment of the invention; and
Figure 5 is a plot of VC or yield data against predicted or reconstructed EPE for (a) a prior art geometry-based EPE reconstruction method; and (b) a data-driven EPE reconstruction method according to an embodiment of the invention .

DETAILED DESCRIPTION OF EXEMPLARY EMBODIMENTS

Before describing embodiments of the invention in detail, it is instructive to present an example environment in which embodiments of the present invention may be implemented.

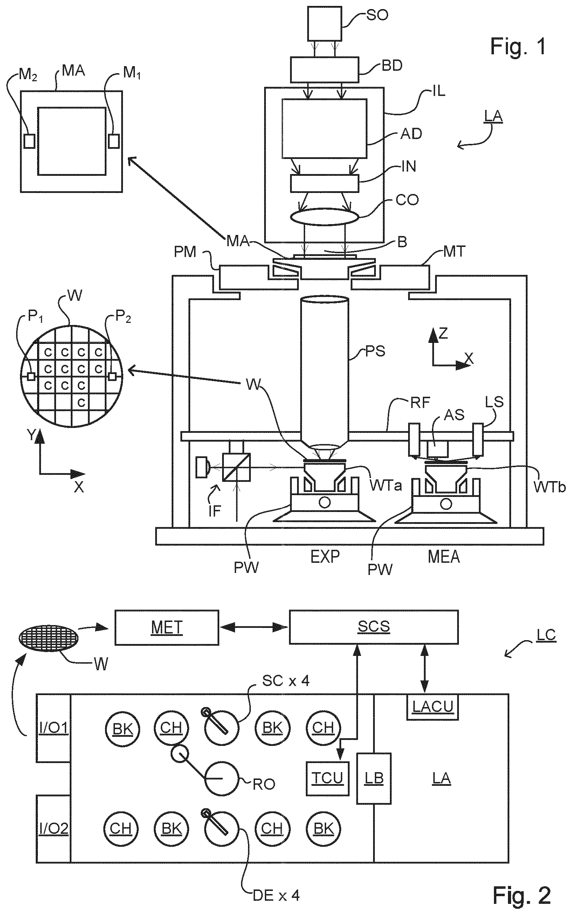

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support holds the patterning device in a manner that depends on the orientation of the patterning device, the design of the lithographic apparatus, and other conditions, such as for example whether or not the patterning device is held in a vacuum environment. The patterning device support can take many forms; the patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., reticle/mask) MA with respect to the path of the radiation beam B, e.g., after mechanical retrieval from a mask library, or during a scan.

Patterning device (e.g., reticle/mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment mark may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

As shown in Figure 2, the lithographic apparatus LA forms part of a lithographic cell LC, also sometimes referred to a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which lithocell LC is located also includes metrology system MET which receives some or all of the substrates W that have been processed in the lithocell. Metrology results are provided directly or indirectly to the supervisory control system SCS. If errors are detected, adjustments may be made to exposures of subsequent substrates, especially if the inspection can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Within metrology system MET, an inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it is desirable that the inspection apparatus measure properties in the exposed resist layer immediately after the exposure. However, the latent image in the resist has a very low contrast - there is only a very small difference in refractive index between the parts of the resist which have been exposed to radiation and those which have not - and not all inspection apparatus have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of faulty substrates but may still provide useful information.

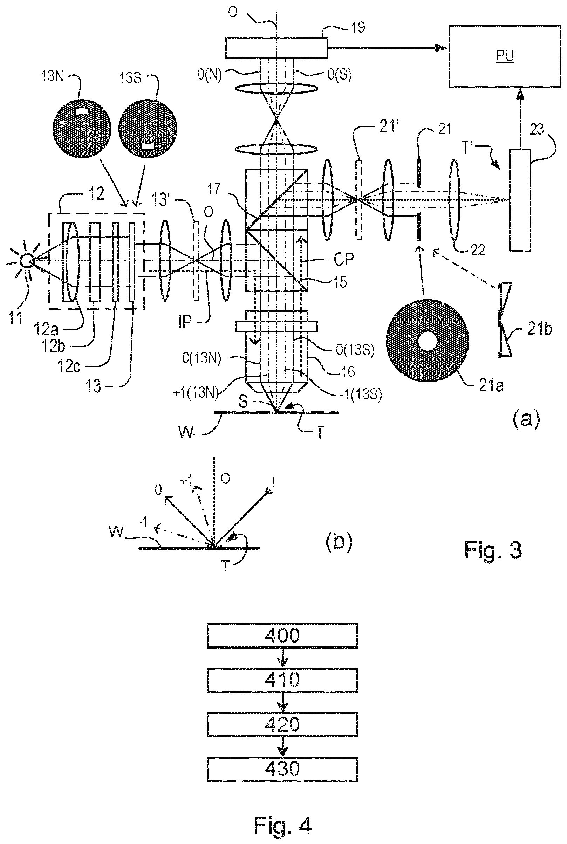

A metrology apparatus suitable for use in embodiments of the invention is shown in Figure 3(a). Note that this is only one example of a suitable metrology apparatus. An alternative suitable metrology apparatus may use EUV radiation such as, for example, that disclosed in WO2017/186483A1. A target structure T and diffracted rays of measurement radiation used to illuminate the target structure are illustrated in more detail in Figure 3(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 3(b), target structure T is placed with substrate W normal to the optical axis O of objective lens 16. The substrate W may be supported by a support (not shown). A ray of measurement radiation I impinging on target structure T from an angle off the axis O gives rise to a zeroth order ray (solid line 0) and two first order rays (dot-chain line +1 and double dot-chain line -1), hereafter referred to as a pair of complementary diffraction orders. It should be noted that the pair of complementary diffraction orders may be any higher order pair; e.g., the +2, -2 pair etc. and is not limited to the first order complementary pair. It should be remembered that with an overfilled small target structure, these rays are just one of many parallel rays covering the area of the substrate including metrology target structure T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the target structures and the illumination angles can be designed or adjusted so that the first order rays entering the objective lens are closely aligned with the central optical axis. The rays illustrated in Figure 3(a) and 3(b) are shown somewhat off axis, purely to enable them to be more easily distinguished in the diagram.

At least the 0 and +1 orders diffracted by the target structure T on substrate W are collected by objective lens 16 and directed back through beam splitter 15. Returning to Figure 3(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target structure on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target structure T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

Position errors may occur due to an overlay error (often referred to as "overlay"). The overlay is the error in placing a first feature during a first exposure relative to a second feature during a second exposure. The lithographic apparatus minimizes the overlay errors by aligning each substrate accurately to a reference prior to patterning. This is done by measuring positions of alignment marks on the substrate using an alignment sensor. More information on the alignment procedure can be found in U.S. Patent Application Publication No. US 2010-0214550. Pattern dimensioning (e.g., CD) errors may, for example, occur when the substrate is not positioned correctly with respect to a focal plane of the lithographic apparatus. These focal position errors may be associated with un-flatness of a substrate surface. The lithographic apparatus aims to minimize these focal position errors by measuring the substrate surface topography prior to patterning using a level sensor. Substrate height corrections are applied during subsequent patterning to help assure correct imaging (focusing) of the patterning device onto the substrate. More information on the level sensor system can be found in U.S. Patent Application Publication No. US 2007-0085991.

Besides the lithographic apparatus LA and the metrology apparatus MT, one or more other processing apparatuses may be used during device production as well. An etching station (not shown) processes the substrates after exposure of the pattern into the resist. The etch station transfers the pattern from the resist into one or more layers underlying the resist layer. Typically etching is based on application of a plasma medium. One or more local etching characteristics may e.g. be controlled using temperature control of the substrate or directing the plasma medium using a voltage controlled ring. More information on etching control can be found in PCT Patent Application Publication No. WO 2011-081645 and U.S. Patent Application Publication No. US 2006-016561.

During the manufacturing of devices, it is desired that the process conditions for processing substrates using one or more processing apparatuses such as the lithographic apparatus or etching station remain stable such that properties of the features remain within certain control limits. Stability of the process is of particular significance for features of the functional parts of an electric device such as an IC, also referred to as product features. To help ensure stable processing, process control capabilities should be in place. Process control involves monitoring of processing data and implementation of means for process correction, e.g. control a processing apparatus based on one or more characteristics of the processing data. Process control may be based on periodic measurement by the metrology apparatus MT, often referred to as "Advanced Process Control" (further also referenced to as APC). More information on APC can be found in U.S. Patent Application Publication No. US 2012-008127. A typical APC implementation involves periodic measurements on metrology features on the substrates to monitor and correct drifts associated with one or more processing apparatuses. The metrology features reflect the response to process variations of the product features. The sensitivity of the metrology features to process variations may be different compared to the sensitivity to the product features. In that case, a so-called "Metrology To Device" offset (also referenced to as MTD) may be determined. One reason for this is MTD offset is that the actual product structures are often much (orders of magnitude) smaller than the size of the target structures which are required for scatterometry or imaging measurements, and this difference in size can result in different parameter behavior (e.g., pattern placement and resulting overlay for metrology targets may differ from pattern placement and resulting overlay of actual structures). To mimic the behavior of product features, features within the metrology targets may be made smaller (e.g., of comparable size to the product structures, which can be referred to as at-resolution overlay ARO), incorporate segmented features, assist features or features with a particular geometry and/or dimension. A carefully designed metrology target ideally should respond in a similar fashion to process variations as do the product features. More information on metrology target design can be found in PCT Patent Application Publication No. WO 2015-101458.

In another approach, metrology may be performed directly on the product structure. This can be done using a scanning electron microscope (SEM) or an e-beam metrology apparatus for example. However, these devices are typically too slow for process control in a commercial (high-volume manufacturing HVM) environment. Another alternative, referred to as in-device metrology IDM, may comprise using a scatterometer based metrology apparatus to measure the product structure (e.g., which has sufficient regularization) directly. Such product structure may have sufficient regularization such that it can act as an effective diffraction grating. Modern scatterometry tools such as illustrated in Figure 3 have the capability of measuring (at least) an asymmetry based metric (e.g., overlay) on such small structures.

Edge placement error (EPE) may be defined as the tolerance of the relative placement of two edges. An EPE which exceeds or is less than the designed EPE margin may cause the local device feature to fail, e.g., by not providing the correct electrical connection or insulation between two layers and/or features; the larger the magnitude of any deviation from designed EPE margin, the greater the probability of failure. EPE variation (e.g., in a single machine/chuck/reticle scenario) may be caused by variation in a number of contributory process parameters which may include, for example: overlay, CD-uniformity (CDU) of the two layers and Line-Width-Roughness (LWR) of the two layers.

Both global parameters and local parameters contribute to the EPE budget. Global parameters may include, for example, one or more of: global overlay, global critical dimension (CD), global tilt and global contact area (CA)/global EPE between structures in successive layers, critical dimension uniformity (CDU), line width roughness (LWR), or line edge roughness (LER). Local parameters may include one or more of: local CD, local overlay (LOVL), local CA/local EPE, local tilt, local side wall angle (SWA), local line placement. The local parameters in particular manifest at spatial scales which are too small to measure using some relatively fast metrology tools such as scatterometers; e.g., those which typically integrate signals across an area (spot size) larger than said spatial scale of variation, and are therefore presently monitored using SEMs (e.g., e-beam tools) or similar tools.

For critical patterning layers, it is desirable to monitor, control and setup a lithographic process based on a placement metric such as an EPE metric, as opposed to using separate overlay and CD metrics, as has been typically the case in the past. Such a combined metric approach provides an improved accuracy.

EPE can be measured directly using for example an SEM (e-beam) metrology tool. However; such direct measurement can only be performed after all the patterning steps of all relevant layers are completed. Additionally, such metrology may be destructive (requiring decapping of the device), rendering the measured device as scrap. It is expected that an EPE metric will correlate highly to local device electrical test measurements, such as Voltage Contrast (VC), etc., and therefore will be indicative of yield.

Because of this, the EPE metric may be reconstructed from measured contributor parameter values such as overlay and CD (e.g., CD stochastic metrology) in monitoring and control applications. Existing EPE reconstruction methods are geometry based; e.g., they use the geometry of the pattern of the relevant two layers to define a formula for reconstructed EPE based on the local statistics of its contributors in a field-of-view (FOV) of an e-beam or other SEM metrology device. Such a geometry based reconstruction method can be summarized in the following steps:

**1.** Obtain Overlay, CD and VC data from one or more setup wafers.

    a. VC data may comprise a ratio of the number of good bits (e.g., which meet a criterion indicative of operability) to the total number of bits in the FOV; e.g., from e-beam images. Any yield proxy or measure of good/operable (or conversely failed/inoperable features) may be used, regardless of metrology technique used; voltage contrast is only an example technique.

    b. CD data may include local CD distribution data in FOV for the respective layers (e.g., a first layer and a second layer); e.g., from e-beam images or other suitable CD metrology method.

Overlay data may comprise global overlay between the layers of interest in FOV. This may be measured from e-beam images or from any other overlay metrology method (e.g., optical metrology such as diffraction based overlay, micro-diffraction based overlay, in-device metrology overlay).

**2.** Choose a distribution quantile value (Q%) and calculate reconstructed EPE at Q% *EPE@Q%* according to:

$$EPE@Q\% = EPE_{DES\,MAR} - OVL@50\% - \frac{1}{2}(CD_{L1} - CD_{L2})@Q\%$$

where *EPE$_{DES\,MAR}$* is the designed EPE margin, *OVL@50%* is overlay at the middle quantile (median overlay), $CD_{L1}$

is a CD metric for layer 1 and $CD_{L2}$ is a CD metric for layer 2.

3. Compare the correlation of *EPE@Q%* to the VC data, e.g., the VC success bit percentage.

4. Repeat steps 2 and 3 with a different value for Q;

5. Choose the Q value that shows the best correlation in step 3.

There are some significant limitations in such a geometric approach. One such limitation is that it is not possible to include multiple quantile value statistics in the geometric formula. There can be loss of critical information due to the use of certain quantile value statistics. The underlying assumption in the geometric model is that the contributors are independent. However, in practice there can be cross-correlation between contributors due to imperfections in the metrology process and common variation root-causes. Additionally, there is no flexibility in the EPE contributors included. As already stated, EPE may be dependent on parameters other than overlay and CD (e.g., LWR), and therefore improved performance may be obtained by including other EPE contributors in the model. The lack of such relevant contributors may introduce a bias and therefore, ideally, the model should be corrected for any biases introduced by missing contributors that correlate with included contributors.

To address the shortcomings of using geometry-driven only approach, a data-driven placement metric or EPE reconstruction method will now be described. Figure 4 is a flowchart describing such a data-driven EPE reconstruction method.

At step 400, setup data is obtained. The setup data may comprise the same overlay, CD and VC data as that described for the geometry based approach discussed above (and as such, step 1 of that method may be applicable to this step). More generally, the VC data may be any yield data or failure analysis data indicative of whether a particular feature or combination of features will function (whether obtained from voltage contrast metrology methods, or otherwise). The CD distribution data for each layer may comprise any suitable distribution measure, such as any suitable CD average, standard deviation of CD or 99 percentile of CD. Also, as will be explained, the model used in this embodiment is flexible and may include one or more EPE contributor variables additional to overlay and CD.

At step 410, a statistical model is defined which provides a prediction indicative of yield or a yield proxy metric. Such a yield proxy may be, for example, the number of successful VC bits in a sample (e.g., within the FOV of a metrology tool) based on measurements of a number of EPE contributors associated with the FOV. The model may be based on generalized linear model (GLM) technique and may support the following structural properties:

a) The yield metric or yield proxy metric (e.g., number of successful or good VC bits per sample area or FOV) may comprise a Binomial distribution with probability *p* of being good. Where the yield metric does not lend itself to a binomial distribution, then this distribution may be adapted according to the metric used.

b) The probability *p* may be obtained by mapping a calibrated placement metric or EPE metric m to [0, 1] domain using, for example, the standard normal cumulative distribution function (CDF) $p=\phi(\sigma \times m+\mu)$, defined in terms of statistical parameters, where $\sigma$ is a parameter that calibrates the scale of EPE metric $m$, $\mu$ is a parameter that calibrates the offset of EPE metric $m$ and $\phi$ is the CDF of standard normal distribution. In practice any CDF function can be chosen based on what best fits the data. However, the choice of normal is based on the common assumption of a Gaussian distribution of the local tolerance effects.

c) The EPE metric may be a function of the measured EPE contributors in the FOV: $m=f(\tilde{X}OVL, \tilde{X}CD_{L1}, \tilde{X}CD_{L2}, \cdots)$, where $\tilde{X}^*$ indicates a measured quantity. This function may be realized using a first-order linear model with trainable coefficients. More generally, this function can be any linear or nonlinear function; e.g., it may be a nonlinear function realized by a Machine Learning model, chosen based on best fit to the data. This EPE metric may be a function of any measured or known placement error contributor or EPE contributor e.g., may be a function of one or more of: LWR, before-etch CD, after-etch CD, any other measureable parameter which may effect EPE, or any one or more machine settings (e.g., dose settings) which effect EPE (e.g., scanner settings, etch settings or other machine settings). Note that, if the EPE metric is a function of a machine setting, a linear model would not be appropriate (a linear model works with direct measurements) and a higher order model should be used.

d) one or more optional constraints may be imposed. For example a metric scale constraint may be imposed. One such metric scale constraint may constrain the rate of change of the metric m to be equal to the rate of change of the reference overlay measurement:

$$\frac{\partial f}{\partial X_{OVL}} = 1$$

An alternative metric scale constraint may comprise constraining the magnitude of the rate of change of the metric m to be two times the magnitude of the rate of change of the reference CD measurement of either (or any) layer:

$$\left|\frac{\partial f}{\partial X_{CD}}\right| = \frac{1}{2}$$

These metric scale constraints are based on the definition of EPE; for example, EPE is, by definition, on the same scale as overlay.

A further constraint may comprise a metric bias constraint where the probability of success is constrained to be half ($p=\frac{1}{2}$) when metric m is equal to the designed EPE margin. Again this is based on the definition of EPE.

At step 420 the coefficients of the function $f$ (i.e., EPE metric $m$) and parameters $\{\sigma, \mu\}$ are fitted. This fitting step may use the setup data based on, for example, a maximum-likelihood estimation using a binomial probability density function (PDF) as the likelihood function. While a linear mapping is described, a higher order model may be used. If $\phi$ and function $f$ is not normal-linear and/or the yield parameter is not derived by binomial distribution, then conventional model selection strategies based on cross-validation may be used to find the best combination of $\phi$ and function $f$ and likelihood function of the yield parameters.

At step 430 the reconstructed EPE metric m is used for monitoring and/or control of the lithographic process. For example, the EPE metric may be translated to a yield probability value which can be used to monitor the process. Such a yield probability value may be used to make rework or guided inspection decisions for example. For a control example, it is possible to observe which parameters result in poor yield as it will be clear from the fitted values which parameters (e.g., $CD_{L1}$, $CD_{L2}$, overlay) should be improved to bring yield into scope from the trained coefficients/model. Corrections for an applicable process can then be determined and applied to improve the yield and bring it into scope.

In the above description, the EPE metric is described in terms of EPE for two layers. However, this does not need to be the case. The EPE metric may describe EPE for more than two layers, and as such may be a function of two or more overlay parameters (e.g., between layer 1 and 2, layer 1 and 3 etc.) and CD (and/or other parameter such as LWR, scanner settings etc.) for all relevant layers. The EPE metric may alternatively relate to a single layer, e.g., whether relating to two process steps in a single layer (for example in a double-patterning process) or a single processing step with some measurements (such as "overlay") compared to an expected position value (i.e., a placement error with respect to an expected position). Of course, the setup data (e.g., obtained at step 400) will depend on the parameters of the model at step 410 as will be clear to the skilled person.

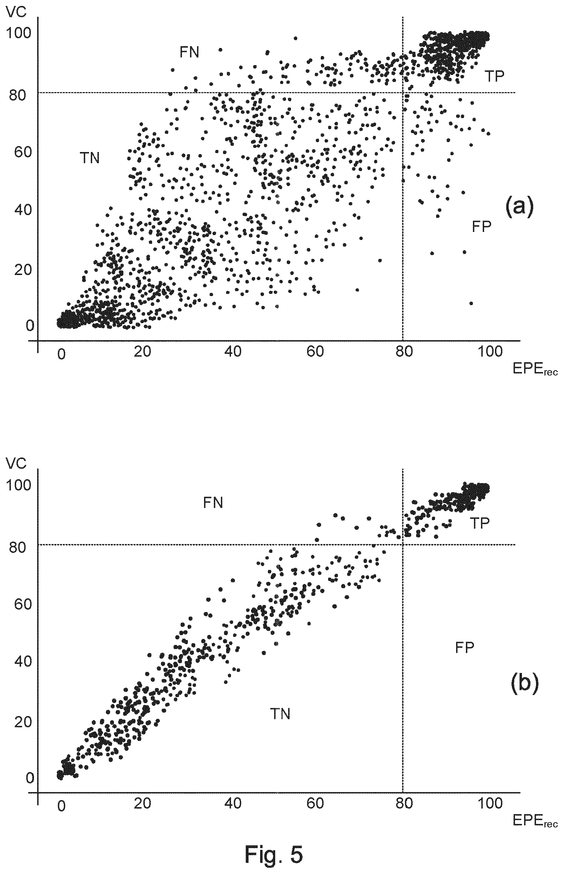

Figure 5(a) is a plot of VC data or other yield proxy data against predicted or reconstructed EPE for a prior art geometry-based EPE reconstruction method. Figure 5(b) is an equivalent plot for a data-driven EPE reconstruction method as disclosed herein. The dotted lines represent an exemplary 80% yield threshold for both axes, dividing the plot into four regions: true positive TP, true negative TN, false positive (lost dies) and false negative FN (false scrap). It can be seen clearly that the predicted EPE data for the proposed method (Figure 5(b)) correlates far better with yield than the prior art method (Figure 5(a)).

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The term target should not be construed to mean only dedicated targets formed for the specific purpose of metrology. The term target should be understood to encompass other structures, including product structures, which have properties suitable for metrology applications.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims

## Claims

1.   A computer program comprising processor readable instructions which, when run on suitable processor controlled apparatus, cause the processor controlled apparatus to determine a placement metric relating to placement of one or more features on a substrate in a lithographic process, the processor readable instructions are configured to:

> obtain setup data comprising placement error contributor data relating to a plurality of placement error contributor parameters and yield data representative of yield;
> define a statistical model for predicting a yield metric, said statistical model being based on a placement metric, said placement metric being a function of said placement error contributor parameters and associated model coefficients;
> fit at least said model coefficients based on said setup data; and
> determine said placement metric from said fitted model coefficients.

2. A computer program as claimed in claim 1, wherein said placement metric relates to relative placement of two or more features.

3. A computer program as claimed in claim 2, wherein said two or more features are distributed over two or more layers.

4. A computer program as claimed in claim 3, wherein said placement error contributor parameters comprise at least at least one overlay metric and at least one critical dimension metric.

5. A computer program as claimed in claim 4, wherein said at least one overlay metric relates to global overlay between one or more pairs of relevant layers and said critical dimension metric relates to a statistical measure of local critical dimension in each of said relevant layers.

6. A computer program as claimed in claim 4 or 5, wherein said at least one critical dimension metric comprises one or both of: a before-etch critical dimension metric and an after-etch critical dimension metric.

7. A computer program as claimed in claim 2, wherein said two or more features are in a single layer formed in at least a first patterning step and second patterning step.

8. A computer program as claimed in claim 7, wherein said placement error contributor parameters comprise at least one global relative position metric between first features of said two or more features formed in said first patterning step and second features of said two or more features formed in said second patterning step; and said critical dimension metric relates to a statistical measure of local critical dimension for each of said first features and second features.

9. A computer program as claimed in claim 1, wherein said placement metric relates to placement of one or more features with respect to an expected position; and
said placement error contributor parameters comprise at least a position metric describing the position of each of said one or more features with respect to its expected position and a statistical measure of local critical dimension in each of one or more features.

10. A computer program as claimed in any preceding claim, wherein said placement error contributor parameters comprise one or more settings of a lithographic apparatus or etch apparatus used to form said one or more features.

11. A computer program as claimed in any preceding claim, wherein said placement error contributor parameters comprise one or more of a line width roughness or line edge roughness metric.

12. A computer program as claimed in any preceding claim, wherein said yield data comprises or is derived from voltage contrast data.

13. A computer program as claimed in claim 12, wherein said yield data comprises the number of good bits per sample area.

14. A computer program as claimed in any preceding claim, wherein:

> said fitting step further comprises fitting of model statistical parameters of said statistical model with said model coefficients; and
> said step of determining said placement metric comprises determining said placement metric from said fitted model coefficients and model statistical parameters.

**15.** A computer program as claimed in any preceding claim, wherein said fitting step uses the setup data based on a maximum-likelihood estimation.

## Patentansprüche

**1.** Ein Computerprogramm, das prozessorlesbare Anweisungen beinhaltet, die, wenn sie auf einer geeigneten prozessorgesteuerten Vorrichtung ausgeführt werden, die prozessorgesteuerte Vorrichtung dazu veranlassen, eine Platzierungskennzahl, die sich auf die Platzierung eines oder mehrerer Merkmale auf einem Substrat in einem lithographischen Prozess bezieht, zu bestimmen, wobei die prozessorlesbaren Anweisungen für Folgendes konfiguriert sind:

Erhalten von Setup-Daten, die Platzierungsfehlerbeiträgerdaten, welche sich auf eine Vielzahl von Platzierungsfehlerbeiträgerparametern beziehen, und Ertragsdaten, welche für einen Ertrag repräsentativ sind, beinhalten;
Definieren eines statistischen Modells zum Vorhersagen einer Ertragskennzahl, wobei das statistische Modell auf einer Platzierungskennzahl basiert, wobei die Platzierungskennzahl eine Funktion der Platzierungsfehlerbeiträgerparameter und zugehöriger Modellkoeffizienten ist;
Anpassen mindestens der Modellkoeffizienten auf der Basis der Setup-Daten; und
Bestimmen der Platzierungskennzahl aus den angepassten Modellkoeffizienten.

**2.** Computerprogramm gemäß Anspruch 1, wobei sich die Platzierungskennzahl auf die relative Platzierung von zwei oder mehr Merkmalen bezieht.

**3.** Computerprogramm gemäß Anspruch 2, wobei die zwei oder mehr Merkmale über zwei oder mehr Schichten verteilt sind.

**4.** Computerprogramm gemäß Anspruch 3, wobei die Platzierungsfehlerbeiträgerparameter mindestens eine Overlay-Kennzahl und mindestens eine Kennzahl kritischer Abmessung beinhalten.

**5.** Computerprogramm gemäß Anspruch 4, wobei sich die mindestens eine Overlay-Kennzahl auf das globale Overlay zwischen einem oder mehreren Paaren relevanter Schichten bezieht und sich die Kennzahl kritischer Abmessung auf ein statistisches Maß lokaler kritischer Abmessung in jeder der relevanten Schichten bezieht.

**6.** Computerprogramm gemäß Anspruch 4 oder 5, wobei die mindestens eine Kennzahl kritischer Abmessung eine oder beide der Folgenden beinhaltet: eine Vor-Ätzungs-Kennzahl kritischer Abmessung und eine Nach-Ätzungs-Kennzahl kritischer Abmessung.

**7.** Computerprogramm gemäß Anspruch 2, wobei sich die zwei oder mehr Merkmale in einer einzigen Schicht befinden, die in mindestens einem ersten Musteraufbringungsschritt und einem zweiten Musteraufbringungsschritt gebildet wird.

**8.** Computerprogramm gemäß Anspruch 7, wobei die Platzierungsfehlerbeiträgerparameter mindestens eine Kennzahl globaler relativer Position zwischen ersten Merkmalen der zwei oder mehr Merkmale, die in dem ersten Musteraufbringungsschritt gebildet werden, und zweiten Merkmalen der zwei oder mehr Merkmale, die in dem zweiten Musteraufbringungsschritt gebildet werden, beinhalten; und sich die Kennzahl kritischer Abmessung auf ein statistisches Maß lokaler kritischer Abmessung für jedes der ersten Merkmale und der zweiten Merkmale bezieht.

**9.** Computerprogramm gemäß Anspruch 1, wobei sich die Platzierungskennzahl auf die Platzierung eines oder mehrerer Merkmale hinsichtlich einer erwarteten Position bezieht; und die Platzierungsfehlerbeiträgerparameter mindestens eine Positionskennzahl, die die Position jedes von dem einen oder den mehreren Merkmalen hinsichtlich seiner erwarteten Position beschreibt, und ein statistisches Maß lokaler kritischer Abmessung in jedem von einem oder mehreren Merkmalen beinhalten.

**10.** Computerprogramm gemäß einem der vorhergehenden Ansprüche, wobei die Platzierungsfehlerbeiträgerparameter eine oder mehrere Einstellungen einer lithographischen Vorrichtung oder Ätzvorrichtung, die zum Bilden des einen oder der mehreren Merkmale verwendet wird, beinhalten.

**11.** Computerprogramm gemäß einem der vorhergehenden Ansprüche, wobei die Platzierungsfehlerbeiträgerparameter eine oder mehrere von einer Linienbreitenrauigkeits- oder Linienkantenrauigkeitskennzahl beinhalten.

**12.** Computerprogramm gemäß einem der vorhergehenden Ansprüche, wobei die Ertragsdaten Spannungskontrastdaten beinhalten oder davon abgeleitet sind.

**13.** Computerprogramm gemäß Anspruch 12, wobei die Ertragsdaten die Anzahl guter Stücke pro Probenfläche beinhalten.

**14.** Computerprogramm gemäß einem der vorhergehenden Ansprüche, wobei:
der Anpassungsschritt ferner das Zur-Passung-Bringen von statistischen Modellparametern des statistischen Modells mit den Modellkoeffizienten beinhaltet; und der Schritt des Bestimmens der Platzierungskennzahl das Bestimmen der Platzierungskennzahl aus den angepassten Modellkoeffizienten und statistischen Modellparametern beinhaltet.

**15.** Computerprogramm gemäß einem der vorhergehenden Ansprüche, wobei der Anpassungsschritt die Setup-Daten auf der Basis einer Maximum-Likelihood-Schätzung verwendet.

**Revendications**

**1.** Un programme d'ordinateur comprenant des instructions lisibles par processeur qui, lorsqu'elles sont exécutées sur un appareil contrôlé par processeur adéquat, amènent l'appareil contrôlé par processeur à déterminer une mesure de placement portant sur un placement d'une ou de plusieurs caractéristiques sur un substrat dans un procédé lithographique, les instructions lisibles par processeur étant configurées pour :

obtenir des données de configuration comprenant des données de contributeurs à une erreur de placement portant sur une pluralité de paramètres contributeurs à une erreur de placement et des données de rendement représentatives d'un rendement ;
définir un modèle statistique pour prédire une mesure de rendement, ledit modèle statistique étant basé sur une mesure de placement, ladite mesure de placement étant une fonction desdits paramètres contributeurs à une erreur de placement et de coefficients de modèle associés ;
ajuster au moins lesdits coefficients de modèle sur la base desdites données de configuration ; et
déterminer ladite mesure de placement à partir desdits coefficients de modèle ajustés.

**2.** Un programme d'ordinateur tel que revendiqué dans la revendication 1, où ladite mesure de placement porte sur un placement relatif de deux caractéristiques ou plus.

**3.** Un programme d'ordinateur tel que revendiqué dans la revendication 2, où lesdites deux caractéristiques ou plus sont distribuées sur deux couches ou plus.

**4.** Un programme d'ordinateur tel que revendiqué dans la revendication 3, où lesdits paramètres contributeurs à une erreur de placement comprennent au moins au moins une mesure d'overlay et au moins une mesure de dimension critique.

**5.** Un programme d'ordinateur tel que revendiqué dans la revendication 4, où ladite au moins une mesure d'overlay porte sur un overlay global entre une ou plusieurs paires de couches pertinentes et ladite mesure de dimension critique porte sur une mesure statistique de dimension critique locale dans chacune desdites couches pertinentes.

**6.** Un programme d'ordinateur tel que revendiqué dans la revendication 4 ou la revendication 5, où ladite au moins une mesure de dimension critique comprend l'une ou l'autre ou l'une et l'autre : d'une mesure de dimension critique avant gravure et d'une mesure de dimension critique après gravure.

**7.** Un programme d'ordinateur tel que revendiqué dans la revendication 2, où lesdites deux caractéristiques ou plus sont dans une seule couche formée lors d'au moins une première étape de conformation selon un motif et une deuxième étape de conformation selon un motif.

**8.** Un programme d'ordinateur tel que revendiqué dans la revendication 7, où lesdits paramètres contributeurs à une erreur de placement comprennent au moins une mesure de position relative globale entre des premières caractéristiques desdites deux caractéristiques ou plus formées lors de ladite première étape de conformation selon un motif et des deuxièmes caractéristiques desdites deux caractéristiques ou plus formées lors de ladite deuxième étape de conformation selon un motif ; et ladite mesure de dimension critique porte sur une mesure statistique de dimension critique locale pour chacune desdites premières caractéristiques et deuxièmes caractéristiques.

9. Un programme d'ordinateur tel que revendiqué dans la revendication 1, où ladite mesure de placement porte sur un placement d'une ou de plusieurs caractéristiques par rapport à une position attendue ; et
lesdits paramètres contributeurs à une erreur de placement comprennent au moins une mesure de position décrivant la position de chacune desdites une ou plusieurs caractéristiques par rapport à sa position attendue et une mesure statistique de dimension critique locale dans chacune des une ou plusieurs caractéristiques.

10. Un programme d'ordinateur tel que revendiqué dans n'importe quelle revendication précédente, où lesdits paramètres contributeurs à une erreur de placement comprennent un ou plusieurs réglages d'un appareil lithographique ou appareil de gravure utilisé pour former lesdites une ou plusieurs caractéristiques.

11. Un programme d'ordinateur tel que revendiqué dans n'importe quelle revendication précédente, où lesdits paramètres contributeurs à une erreur de placement comprennent un ou plusieurs éléments parmi une mesure de rugosité en largeur de ligne *(line width roughness)* ou de rugosité en bord de ligne *(line edge roughness)*.

12. Un programme d'ordinateur tel que revendiqué dans n'importe quelle revendication précédente, où lesdites données de rendement comprennent ou sont dérivées de données de contraste de tension.

13. Un programme d'ordinateur tel que revendiqué dans la revendication 12, où lesdites données de rendement comprennent le nombre de bons morceaux par zone d'échantillonnage.

14. Un programme d'ordinateur tel que revendiqué dans n'importe quelle revendication précédente, où :

ladite étape d'ajustement comprend en sus l'ajustement de paramètres statistiques modèles dudit modèle statistique avec lesdits coefficients de modèle ; et
ladite étape de détermination de ladite mesure de placement comprend la détermination de ladite mesure de placement à partir desdits coefficients de modèle et paramètres statistiques modèles ajustés.

15. Un programme d'ordinateur tel que revendiqué dans n'importe quelle revendication précédente, où ladite étape d'ajustement utilise les données de configuration sur la base d'une estimation du maximum de vraisemblance.

Fig. 1

Fig. 2

(a)

(b)

Fig. 3

Fig. 4

Fig. 5

**REFERENCES CITED IN THE DESCRIPTION**

**Patent documents cited in the description**

- US 2006033921 A1
- US 2010201963 A1
- US 20100328655 A1
- US 2011069292 A1
- US 20110027704 A
- US 20110043791 A
- US 2011102753 A1
- US 20120044470 A
- US 20120123581 A
- US 20130258310 A
- US 20130271740 A
- WO 2013178422 A1
- WO 2021037484 A1
- WO 2017186483 A1
- US 20100214550 A
- US 20070085991 A
- WO 2011081645 A
- US 2006016561 A
- US 2012008127 A
- WO 2015101458 A